(19) Europäisches Patentamt
European Patent Office
Office européen des brevets

(11) Publication number: **0 292 219**
**A2**

(12) **EUROPEAN PATENT APPLICATION**

(21) Application number: **88304414.1**

(22) Date of filing: **16.05.88**

(51) Int. Cl.[4]: **G03F 7/10 , G03C 1/68 , H05K 3/34**

(30) Priority: **21.05.87 US 52326**

(43) Date of publication of application: **23.11.88 Bulletin 88/47**

(84) Designated Contracting States: **DE FR GB IT NL**

(71) Applicant: **AMERICAN TELEPHONE AND TELEGRAPH COMPANY**
**550 Madison Avenue**
**New York, NY 10022(US)**

(72) Inventor: **Ors, Jose Alberto**
**Box 564**
**New Hope Pennsylvania 18938(US)**
Inventor: **Wight, Frederick Richard**
**489 King George Road**
**Basking Ridge New Jersey 07920(US)**

(74) Representative: **Johnston, Kenneth Graham et al**
**AT&T (UK) LTD. AT&T Intellectual Property Division 5 Mornington Road**
**Woodford Green Essex, IG8 OTU(GB)**

(54) **Printed circuit board fabrication.**

(57) Photosensitive materials useful in the manufacture of printed circuit boards are advantageously formed from an epoxy acrylate that has been acidified utilizing an acid anhydride such as succinic anhydride. For example, solder masks and resists based on these materials are processed utilizing aqueous solutions and thus significantly simplify the manufacturing procedure.

EP 0 292 219 A2

Xerox Copy Centre

# PRINTED CIRCUIT BOARD FABRICATION

## Background of the Invention

### 1. Technical Field

This invention relates to the manufacture of electronic components and in particular the manufacture of printed wire circuit boards.

### 2. Description of the Prior Art

The fabrication of printed wire circuit boards (PWB) involves several procedures that require the photodefinition of a polymer material. For example, three such procedures denominated the additive, the substractive, and the semi-additive processes are conventionally employed to produce a metal pattern on a PWB substrate. (See F. Coombs, Jr., Printed Circuits Handbook, McGraw Hill (1979) for a description of these processes.) Briefly, in the subtractive method a metal layer having a thickness of approximately 0.3 to 3 mils is bonded to the surface of the substrate by a procedure such as a hot press lamination process. A photoresist is then coated onto the copper layer. (For pedagogic reasons copper will be used when referring to the metallization step. However, the particular metal is not critical and other metals are employable.) The photoresist is exposed to radiation and developed so that the areas of the copper that ultimately are to form the desired copper pattern remain covered. The portions of the copper layer that are not covered by the delineated photoresist are removed by etching leaving the desired copper pattern. After etching the photoresist is solvated.

Both the additive and the semi-additive techniques require the deposition of a conductor such as copper on an insulator, e.g., a typical substrate. When electroless deposition is employed it is generally necessary to use specific adherence promoting steps. The steps are conventional and typically include treatment with a solvent such as dimethyl formamide to swell the insulating material and treatment with an acid, e.g., chromic acid, to etch the insulating material. It is also possible to achieve the desired adherence by using deposition techniques such as evaporation or sputtering.

As discussed, the semi-additive process includes the steps of initially promoting adhesion by, for example, swelling and etching the surface of the substrate with a solvent such as dimethyl formamide to produce swelling and treatment such as chromic acid to produce etching. A layer of a conductive material such as copper approximately 10 to 50 microinches thick is then plated onto the substrate by electroless plating. (Electroless plating processes are fully described in literature references such as W. Goldie, Metallic Coating of Plastics, Electrochemical Publications [1968].) The deposited conductive material layer, e.g., the copper layer, is coated with a photoresist. The photoresist is patterned so that upon development only the areas of the copper plating which do not ultimately form the desired pattern are covered by the resist material. The thickness of the exposed copper portions is increased to a total thickness of approximately 0.0003-0.003 inches by conventional electroplating. Following the plating the photoresist is removed using a solvent. The entire copper surface is then exposed to an etchant such as ammonium persulfate for a period sufficient to remove the thin copper areas that were covered by the resist. (The thicker copper areas are somewhat thinned by this etching but still have a substantial thickness.) It is also possible before removing the delineated photoresist to deposit a thin layer (0.0001 to 0.0005 inches) of a tin-lead alloy. After the photoresist is removed and etching is begun, the tin entirely protects the underlying portions of the copper pattern.

The fully additive process in one embodiment involves first applying and delineating the photoresist so that the areas of the substrate where the copper pattern is to be deposited are uncovered. The resist coated substrate is then treated to promote adhesion by the process described previously. The treated substrate is subjected to catalytic palladium. (See Metallic Coating of Plastics, supra.) If desired, the delineated substrate is subjected to an electroless copper plating bath for periods typically on the order of 3 to 10 minutes to yield a copper pattern thickness of about 10-50 microinches. (See Metallic Coating of Plastics, supra, for a description of an electroless copper plating method suitable for this procedure.) The photoresist is then removed and the copper pattern increased to a thickness of approximately 1 mil by, for example,

electroless plating (as described above) for typically 18 hours.

Additional steps in PWB manufacture also require a delineable polymer. In particular typical PWBs include a solder mask. This mask is a delineated polymer layer with open areas at positions where soldering is desired. The solder mask protects the metallized pattern from possible shorts induced by remnants of the soldering procedure.

Each process utilizing a photodefinable material, e.g., a resist or solder mask, requires a development after exposure. A variety of solvents have been contemplated for this removal procedure. However, it is particularly advantageous to utilize an aqueous based solvent since difficulties in handling and disposal of the solvent are significantly reduced. Further, a photoresist after development and subsequent processing is removed. It is again desirable to utilize an aqueous based solvent for this removal.

Additional properties are also desirable in photodefinable materials utilized in the fabrication of PWBs. For example, in the case of a photoresist, the photodefinable material must be sufficiently robust to endure, without substantial degradation, the chemical processing required for etching or metallization, e.g., sputtering and/or electroless plating. The desire to have a photodefinable material that is resistant to the compounds and conditions utilized in etching or metallization, and yet that is developed and subsequently stripped by an aqueous medium is a difficult combination of properties to satisfy. Similarly, a solder mask must be heat insensitive to endure the soldering process and have suitable electrical properties to prevent shorting between metallized regions. Again the attainment of all these properties together with the ability to develop an aqueous solvent is extremely difficult to achieve.

## Summary of the Invention

Photosensitive polymeric materials based on epoxy acrylates that have been reacted in suitable proportion with cyclic acid anhydrides yield the desired properties for a resist or solder mask while allowing processing with aqueous media. For example, an epoxy acrylate such as Novacure 3700 (a product of Interez, Inc.) which is basically represented by the formula

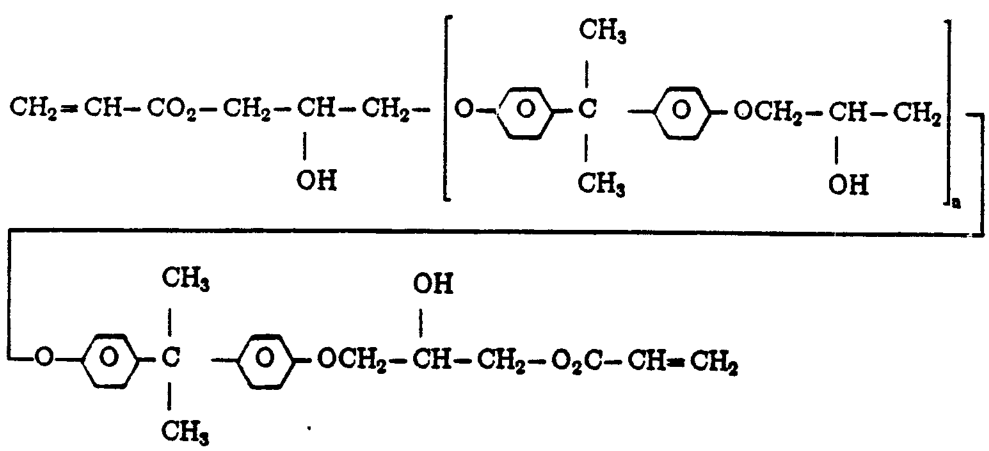

that has been reacted with succinic anhydride to yield an acid number of 145 is suitable as a photoresist that develops in 1% by weight aqueous sodium carbonate. When such modified epoxy acrylates are used with an acid functional acrylate (i.e., the reaction product of hydroxyethyl acrylate and an alkyl or alkenyl anhydride, e.g., dodecenyl succinic anhydride), the resulting photoresist not only develops in aqueous base, but the cured polymer film strips in a 3N sodium hydroxide solution. Similarly, an epoxy acrylate modified with an acid anhydride, e.g., succinic anhydride to have an acid number of 30 is useful as a solder mask that is developed in 1% by weight aqueous sodium carbonate.

## Detailed Description

The inventive processes involve the use of a photosensitive material based on an epoxy acrylate that has been reacted with a cyclic acid anhydride to have a desired acidity. The particular amount of acid moieties introduced, and thus the particular range of acidity, is chosen depending on the ultimate use of the

photodelineable material. For example, for use as a photoresist in producing PWBs by processes such as the additive, semi-additive, and/or subtractive procedure, the epoxy acrylate material should have an acid number of at least 10. (Acid number is defined as the number of milligrams of potassium hydroxide required to neutralize one gram of the acid functional material.) Acid numbers less than 10 are not desirable because the resulting composition will not be readily developable or strippable in an aqueous alkaline medium. If the composition is to be used as a solder mask, then it is desirable that the acid number be in the range 10 to typically 130. Acid numbers for a solder mask of less than 10 are disadvantageous also because they adversely affect development or stripping in an aqueous alkaline medium while acid numbers above 130 are also undesirable because they tend to raise the acidity of the total composition sufficiently to degrade electrical insulating properties.

A variety of epoxy acrylates are useful in forming the photodefinable material of the invention. Epoxy acrylates are producible by reacting a phenol such as bisphenol-A or bisphenol-F with epichlorohydrin and reacting the resulting product with acrylic acid. Examples of such epoxy acrylates are Novacure 3700 (a product of Interez) and Epocryl 370 (a product of Shell Chemical Company) which are represented by formula (1). For the solder mask preparation it is possible to include rubber block regions in the epoxy acrylate polymer. For example, a product represented by the formula

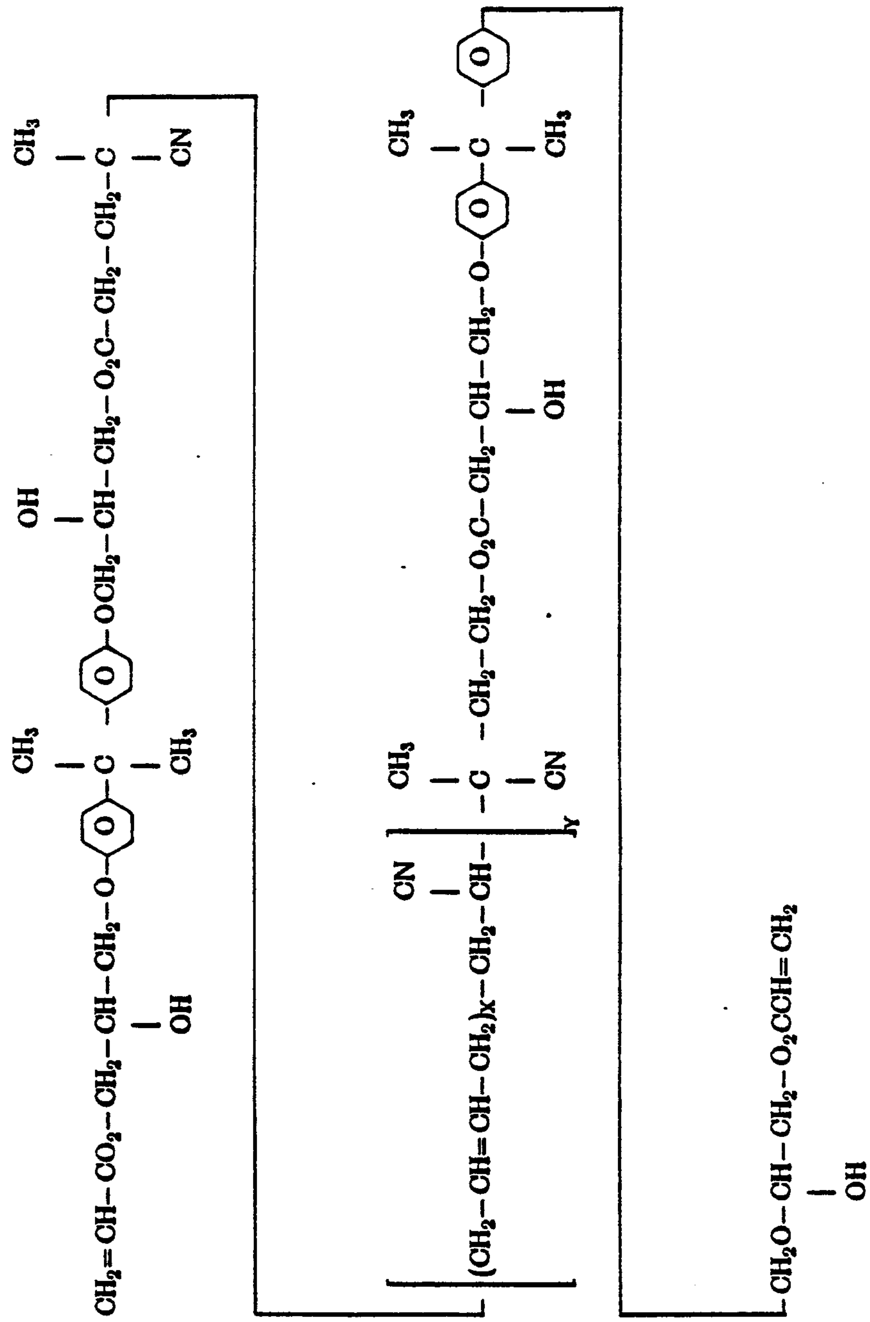

is suitable. The additional rubber block regions yield properties of toughness and adhesiveness which are desirable in a solder mask material. Other substituents besides acid functions are suitable for the epoxy acrylate provided those substituents do not decrease the acid number of the material below the desired level. For example, the presence of bromine substituents enhance the fire retardancy properties of a solder mask, e.g., fire retardancy is afforded by RDX-51027, a product of Interez, represented by the formula

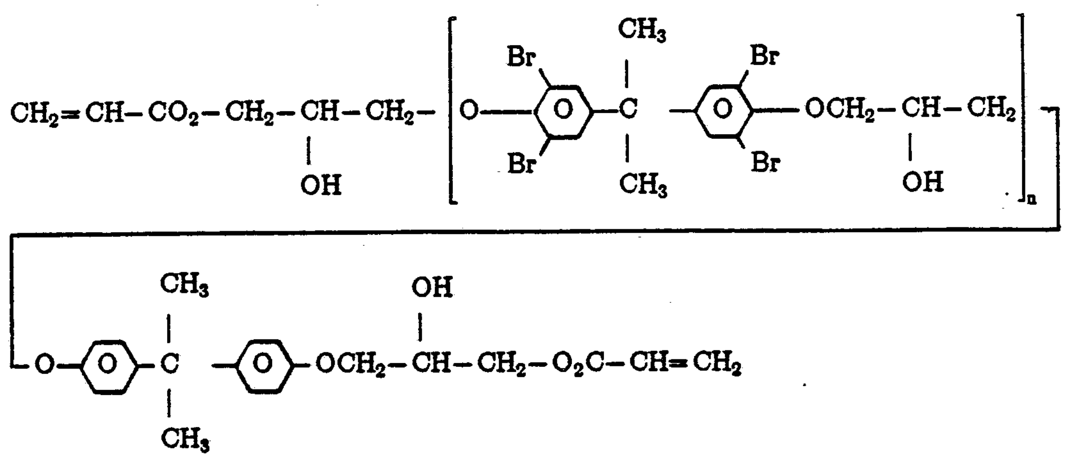

Typically, a minimum of 5% bromine by weight is employed in the solder mask to enhance fire retardancy. The amount of bromine in the total formulation is advantageously controlled by adjusting the amount of bromine containing epoxy acrylate in the formulation or adjusting the ratio of bromine containing to non-bromine containing epoxy acrylate. This percentage should be increased somewhat as the mask thickness approaches the substrate thickness and for particularly flammable substrates.

The particular acid anhydride utilized to react with the epoxy acrylate is not critical. Cyclic acid anhydrides such as succinic, maleic, glutaric, pthalic, hexahydrophthalic, methyl-tetrahydrophthalic, nadic methyl, and chlorendic anhydride are useful for such reaction. The reaction between the epoxy acrylate and the cyclic acid anhydride is performed by conventional techniques described in Organic Chemistry, 3rd Ed., R. T. Morrison and R. N. Boyd, pages 669 to 673 (Allyn and Bacon, 1973). Briefly, this reaction involves the addition of the anhydride to the epoxy acrylate with a catalyst such as triethyl amine or pyridine and heating to 100 to 120°C for one to two hours until the anhydride is substantially consumed by the reaction. A typical reaction is represented by the formula.

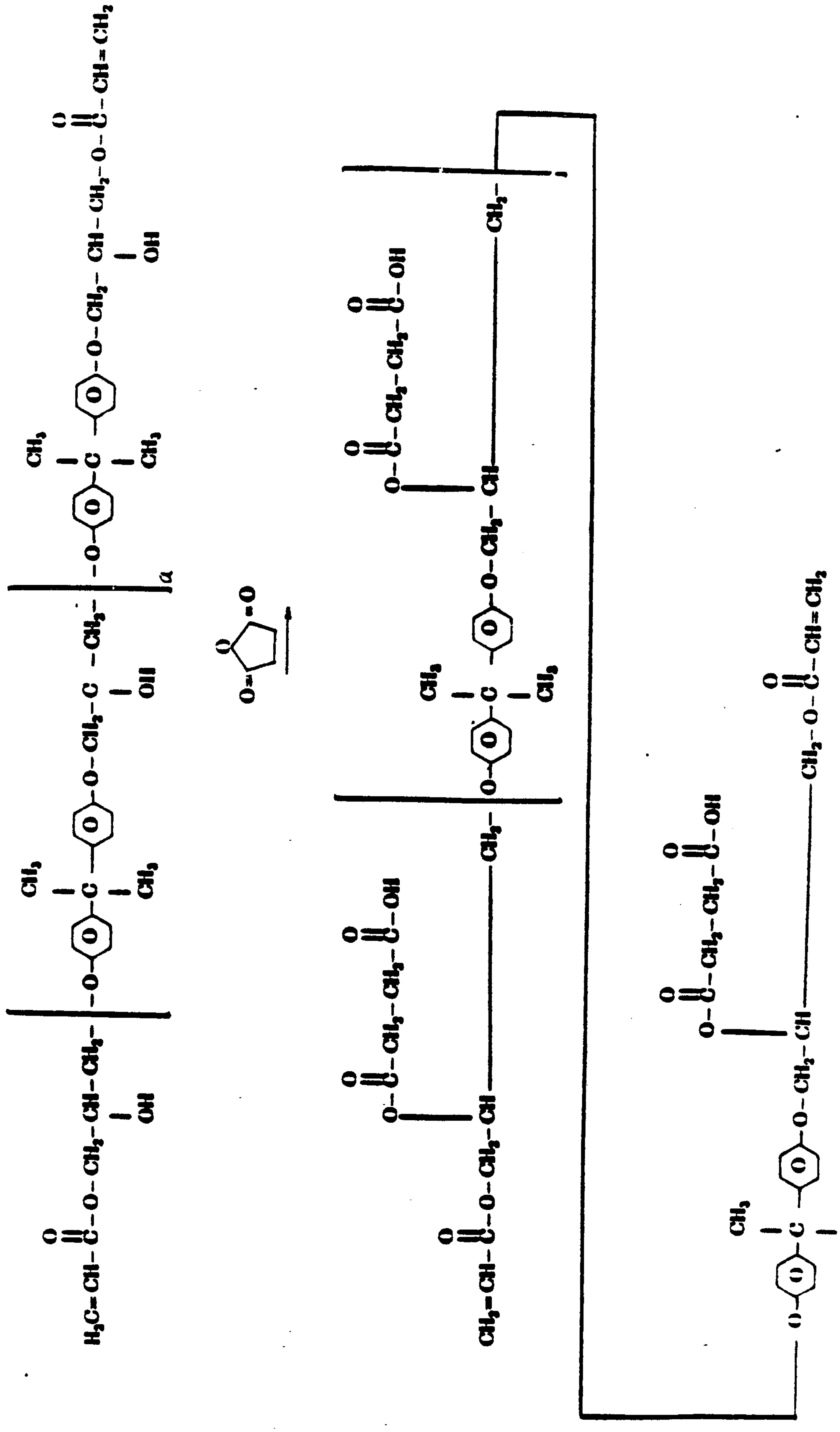

As discussed, the acidity of the photodefinable material is significant. Typically the acid number is controlled by in turn controlling the ratio of reactant. A control sample is employed to determine a suitable ratio for a desired acid number. However, since the reaction between the acrylate and the anhydride occurs at essentially 100% yield, the ratio of reactants determines the desired acid number. Once the photoresist is delineated, it is generally cured with ultraviolet light to yield the desired physical and chemical properties for subsequent processing. After the photoresist is employed to process an underlying surface, it is generally desirable to remove it. To effect this stripping, it is beneficial to include in the material before exposure an acid functional acrylate monomer derived from the reaction of a hydroxy alkyl acrylate such as hydroxy ethyl acrylate and an alkyl or alkenyl cyclic anhydride such as a dodecenyl succinic anhydride as shown in

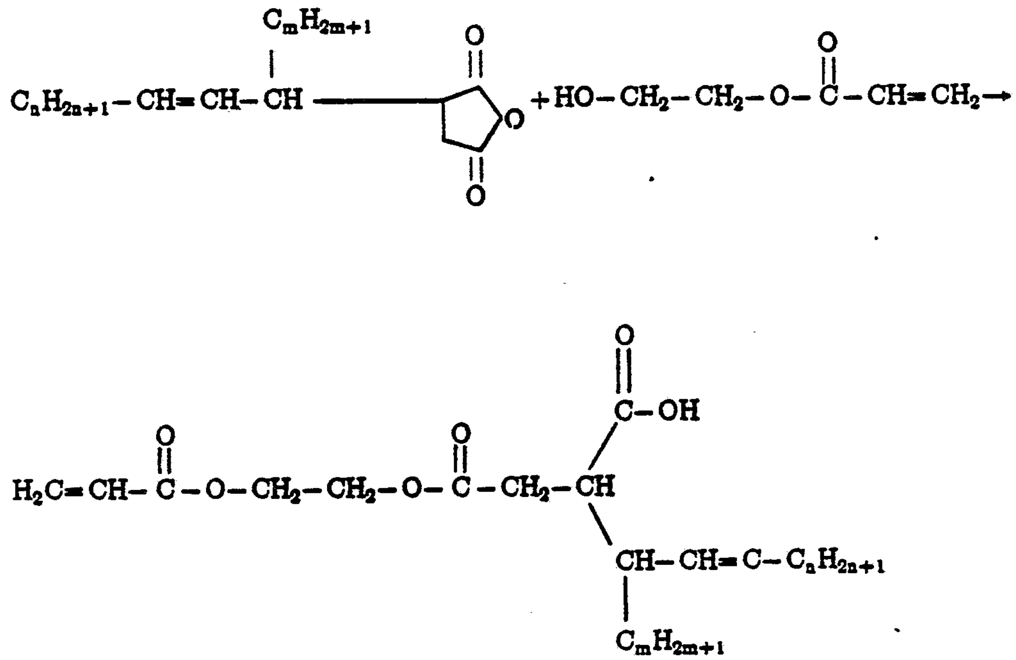

The resulting alkyl or alkenyl side chain imparts chemical resistance to aqueous etching and aqueous plating solutions while the acid functional group renders the cured material soluble in alkaline solution. Typically to obtain these properties a side chain having six to eighteen carbon atoms is employed.

The epoxy acrylates are generally relatively viscous. This viscosity makes handling and coating of the material on a substrate quite difficult. A variety of techniques are available for reducing the viscosity of the material to a more manageable level. The basic desire is to form a material that has a viscosity suitable for the method chosen to apply the mixture to the desired substrate. (For typical coating procedure such as curtain coating, roller coating, spin coating, spray coating, or dip coating, viscosities in the range 120 to 100,000 centipoise are desirable.) In one technique, the composition is solvated by a suitable medium such as acetone, methyl ethyl ketone, methylene chloride, Cellosolve, Cellosolve acetate, or Carbitol. If a solvent is employed, the solvent, after coating, is generally removed from the material by simply heating the mixture. However, the temperature used to remove the solvent should typically be less than 125 to 150°C to avoid initiating a reaction in the photosensitive material.

Another means for reducing viscosity involves the use of a reactive (mono or multifunctional) monomer, i.e., a monomer that reacts under the influence of electromagnetic radiation with the epoxy acrylate composition. For appropriate reactivity, the monomer should have unsaturated groups such as vinyl, acrylic, or methacrylic. The reactive groups are chosen so that they lead upon exposure by radiation, e.g., electromagnetic radiation, to a polymerization reaction in the energy sensitive composition. Generally a low viscosity (less than 500 centipoise) reactive monomer is added to reduce the viscosity of the entire composition. To accomplish this purpose, the molecular weight of the monomer should generally be less than 500. By utilizing a reactive monomer it is possible to advantageously adjust the properties of the photosensitive material. For example, with a solder mask a reactive monomer is added to provide not only lower viscosity but also suitable electrical and solvent resistance and solder blister resistance properties. Similarly, for a photoresist a reactive monomer is added to enhance properties such as resistance to

chemical etching and plating solutions. Exemplary of suitable monomers are 1) monofunctional monomers such as ethoxy ethoxy ethyl acrylate, isobornyl acrylate, isodecyl acrylate, caprolactone acrylate, and lauryl acrylate, 2) difunctional acrylates such as hexanediol diacrylate, tripropylene glycol diacrylate, and pentadecanediol diacrylate, and 3) tri and tetra functional acrylates such as trimethylol propane, triacrylate, and pentaerythritol tetraacrylate. For the solder mask higher functional monomers are employed since they yield enhanced electrical resistance. For photoresist applications lower functional monomers are preferred because they yield materials that are easier to strip. Generally, the reactive monomer constitutes between 10 and 70 weight percent of the photosensitive composition. The precise amount employed depends on the coating technique and the desired viscosity. A control sample is easily used to determine a suitable monomer concentration for a desired circumstance.

It is also possible to include additives with the photosensitive material. For example, a photosensitizer is generally added to insure suitable sensitivity of the materials upon exposure. Photosensitizers such as diethoxy acetophenone and dimethoxy phenyl acetophenone (Irgacure 651) are employed typically in concentrations from 0.5 to 10 weight percent. Other additives such as glow modifiers, pigments, and dyes are also appropriately employable.

The energy sensitive materials of the invention are suitably exposed in a desired pattern utilizing light in the wavelength range 300 to 400nm. Generally doses in the range 20 to 200 milliJoules produce desirable images. The exposed material with its latent image is then developed utilizing suitable solvents such as an aqueous alkaline solution, e.g., sodium or potassium carbonate, in concentrations from 0.25 to 5 weight percent. The delineated photoresist is employed as previously described to produce a printed wire circuit board. The solder masks are also employed as previously described to protect the PWB during the soldering procedure.

The following examples are illustrative of the invention.

## Example 1

One hundred grams of the rubber modified epoxy acrylate, RDX-51043 from Interez, represented by Equation 2 having 0.28 hydroxyl equivalents was combined with 14g (0.14 equivalents) of succinic anhydride, 0.1g of pyridine as a catalyst, and 25g of isobornyl acrylate as a viscosity reducer. (Process for synthesizing the rubber modified epoxy is discussed in U.S. Application 330,011 filed December 11, 1981 which is incorporated by reference.) The mixture was heated with mechanical agitation to 120°C for approximately one hour. The resulting material exhibited no infrared anhydride carbonyl bands and had an acid value of 61.0 and a viscosity (at 150°F) of 15,600 centipoise.

The same procedure was performed utilizing for each experimental run the constituents shown in the table.

| RUN | ACRYLATE | ANHYDRIDE | MONOMER (VISCOSITY MODIFIER) | CATALYST | ADDITIONAL CONSTITUENT | ACID NUMBER | VISCOSITY (CENTIPOISE) |
|---|---|---|---|---|---|---|---|
| 1 | 100g bea*[1] | 11g succinic | 25g ia* | .1g pyridine | ----- | 48.7 | 6,120 at 150°F |
| 2 | 44g rmea*[2]<br>36g bea* | 10.1g succinic | 40g ia* | .1g pyridine | ----- | 44.9 | 2,035 at 150°F |
| 3 | 44g rmea*[2]<br>36g bea* | 16.6g mt* | 40g ia* | .1g pyridine | ----- | 44.2 | 6,620 at 150°F |
| 4 | 13.2g rmea*[2]<br>26.5g bea* | 5.3g hex* | 33.1g ia* | .1g pyridine | ----- | 26.5 | ----- |
| 5 | 20.5g rmea*[2]<br>16.9g bea* | 7.3g hex* | ----- | .1g pyridine | ----- | 39.9 | ----- |
| 6 | 130g Novacure 3700*[3] | 44.2g succinic | 43.5g eeea* | .1g pyridine | ----- | 115 | 11,000 at 25°C |
| 7 | 31.4g hea*[4] | 68.6g ds* | ----- | .15g pyridine | 50mg pmpi* | 154 | 3,500 at 25°C |
| 8 | 26.8g hea*[4] | 73.2g as* | ----- | ----- | 50mg pmpi* | 138 | 1,100 at 25°F |

1 acrylate shown in Equation 3 having 0.22 hydroxyl equivalents
2 acrylate shown in Equation 2 having 0.28 hydroxyl equivalents
3 acrylate shown in Equation 1 having 0.49 hydroxyl equivalents
4 mixture was heated to 110°C for one hour

* as = alkenyl succinic
bea = brominated epoxy acrylate (Equation 3)
ds = dodecenyl succinic
eeea=ethoxy ethoxy ethyl acrylate
hea = hydroxy ethyl acrylate
hex = hexahydrophthalic
ia = isobornyl acrylate
mt = methyl tetrahydrophthalic
pmpi = p-methoxy phenol inhibitor
rmea = rubber modified epoxy acrylate

Example 2

A photodefinable solder mask was prepared by mixing 65g of material obtained in Run 2 with 35g of tripropylene glycol diacrylate, 3g of Irgacure 651 (a proprietary product of Ciba Geigy which is basically dimethoxy phenyl acetophenone), 1g of green pigment paste 9G5 (a proprietary product of Penn Color Inc.), and 0.5g of Modaflow (a proprietary product of Monsanto which is basically a polyacrylic resin). The resulting mixture had a viscosity of 1960 centipoise at 25°C and an acid number of 25.

Example 3

A photodefinable solder mask was prepared by mixing 70g of the material from Run 3 with 30g of Chemlink 2000 (a C14 to C15 acrylate product of Sartomer Co.). The remaining constituents of Example 2 were utilized including the Irgacure, the pigments, and the Modaflow. The mixture had a viscosity of 2350 centipoise at 25°C.

Example 4

A mask was prepared by combining 78g of the material from Run 4 with 22g of tripropylene glycol diacrylate, 3g Irgacure 651, 1g of 9G5 pigment, and 0.5g of Modaflow. The mixture had an acid number of 20 and a viscosity of 1420 centipoise at 25°C.

Example 5

A mask was prepared by mixing 70g of the material from Run 5 with 30g of tripropylene glycol diacrylate, 3g of Irgacure 651, 1g of 9G5 pigment, and 0.5g of Modaflow. The mixture had an acid number of 25.1.

Example 6

A resist was prepared by mixing 37.5g of the material from Run 6, 50g of the material from Run 7, 2.5g of ethoxy ethyoxy ethyl acrylate, 10g of Aronix M111 (a proprietary product of Toagosei Chemical Industry Co., Ltd., which is basically an ethoxylated nonyl phenol monoacrylate), 5g of Irgacure 651, and 3g of a red pigment denominated RD14976 from Penn Color. The material had a viscosity of 2880 centipoise at 25°C and an acid number of 117.5.

Example 7

A resist was prepared by mixing 37.5g of the material from Example 6 with 50g of the material from Example 8, 12.5g of Aronix M111, 5g of Irgacure 651, and 2g of pigment 9G5. The material had a viscosity of 2220 centipoise at 25°C and an acid number of 106.

Example 8

A resist was prepared by mixing 25g of RDX-72766 (an acid functional epoxy acrylate with an acid number 124 sold by Interez), 15g of lauryl acrylate, 10g of Tone M100 (a proprietary product of Union Carbide Corporation, which is basically caprolactone acrylate), 50g of the material from Run 7, 10g of Irgacure 651, and 2g of blue pigment paste denominated 9S87 from Penn Color. This mixture had an acid number of 96 and a viscosity of 1700 centipoise at 25°C.

Example 9

The solder mask from Example 2 was applied to a printed circuit board with a glass reinforced epoxy substrate and a copper metallization in an IPC number B-25 test pattern. The mask material was spread using a threaded rod with 40 threads per inch. The liquid material was blanket exposed to light from a mercury arc lamp having an intensity of 25 mw/cm$^2$ (365 nm) for five seconds. A 5 mil wide annular ring of uncured material was removed from around each hole by spraying the board with 1% aqueous sodium carbonate solution for 30 seconds at 35°C. The coating was then again blanket exposed by passing the board under two 200 watt per inch high pressure mercury vapor lamps at a rate of 10 feet per minute. The board was then brushed with solder flux and dipped in molten solder at 260°C for five seconds. The mask did not blister and a uniform solder coating was formed on the copper annular rings surrounding the holes. The board was aged for 72 hours at 35°C and 90% relative humidity. The insulation resistance of the fine line comb portion of the pattern exceeded $1x10^{10}$ohm. The solder mask formulations of Examples 3, 4, and 5 were coated on a substrate by the same procedure and similar results were obtained.

Example 10

The photoresist of Example 6 was applied to a copper clad printed circuit board, by utilizing a threaded rod having 64 threads per inch. The material was exposed through an IPC A-20 mask utilizing a mercury arc lamp with an intensity of 25 mw/cm$^2$ for five seconds. The resist was developed with a spray of 1% aqueous sodium carbonate for 30 seconds at 35°C. The resist was cured by passing it under two 200 watt per inch mercury lamps at a rate of 40 feet per minute. The exposed copper was etched by immersion in a solution containing 2.2M cupric chloride, 0.5N hydrochloric acid, and 3M sodium chloride at 130°F for approximately four minutes. The resist was stripped by immersing the board in 3N sodium hydroxide at 160°F for approximately one minute. A well defined copper circuit pattern was obtained.

Example 11

The photoresist of Example 7 was applied to a circuit board having an epoxy coating using a threaded rod with 64 threads per inch. The resist was exposed and developed as described in the previous example. The resist was cured as in the previous example, except a speed of ten feet per minute was utilized. The board was then immersed with a 30 second water rinse between each immersion sequentially in 69% dimethyl formamide in water for four minutes at 41°C, 100g per liter of chromic acid for six minutes at 40°C, 40g per liter aqueous sodium metabisulfite for two minutes at room temperature. The board was then subjected to an electroless deposition utilizing 9070 catalyst, 9071 accelerator, and 9072 electroless plating bath, all proprietary products of MacDermid Chemicals. The photoresist was stripped by immersion in 3N sodium hydroxide for three minutes at 160°F. The board was then immersed in an electroless copper bath (9620 electroless copper bath from MacDermid) for 18 hours. The procedure resulted in a well defined circuit pattern.

**Claims**

1. A process for producing a printed circuit wiring board comprising the steps of coating a substrate with a photosensitive material, subjecting said material to actinic radiation, developing said exposed material and completing said wiring board

CHARACTERIZED IN THAT

said material comprises a compound that is describable as the reaction product of an epoxy acrylate composition with a cyclic acid anhydride such that said material has an acid number of at least 10 and said development is accomplished with an aqueous based developer.

2. The process of claim 1 wherein said completion of said board includes the step of using said material as a solder mask during soldering.

3. The process of claim 2 wherein said acid number is less than 130.

4. The process of claim 1 wherein said completion of said board includes the step of using said material as a mask for treating said underlying substrate.

5. The process of claim 4 wherein said treatment comprises etching of an underlying metal.

6. The process of claim 4 wherein said treatment comprises metallizing said underlying substrate.

7. The process of claim 1 wherein said material comprises the reaction product of

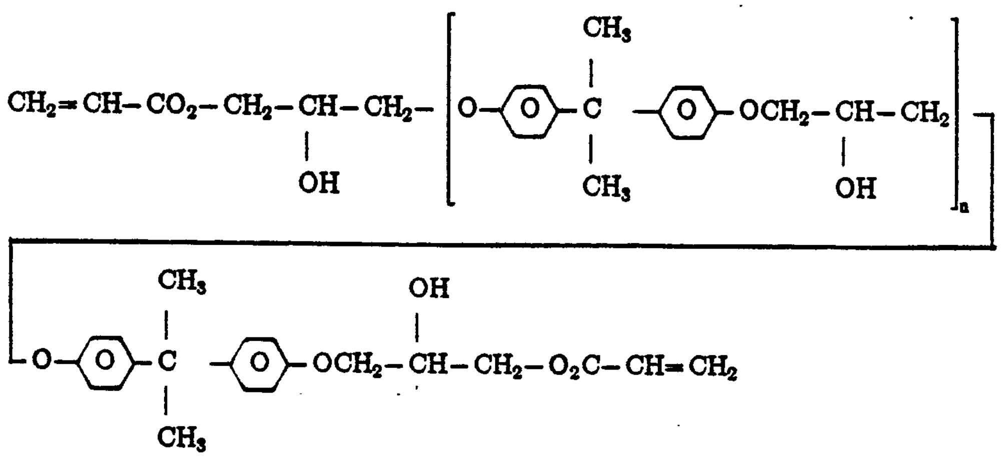

with said cyclic acid anhydride.

8. The process of claim 7 wherein said cyclic acid anhydride comprises succinic anhydride.

9. The process of claim 1 wherein said epoxy acrylate includes a rubber block region.

10. The process of claim 9 wherein said epoxy acrylate comprises

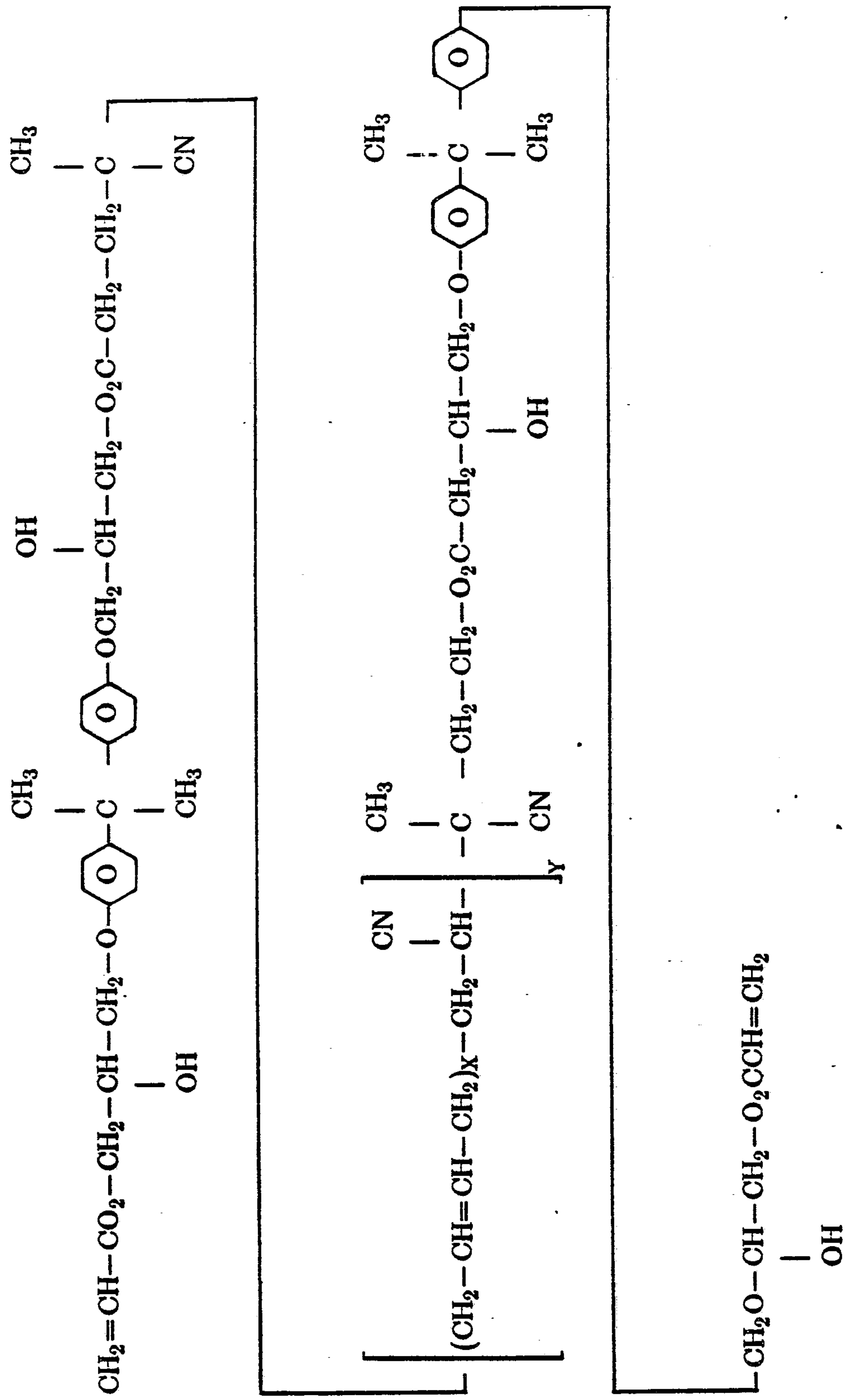

11. The process of claim 1 wherein said cyclic acid anhydride is chosen from the group consisting of succinic, maleic, glutaric, phthalic, hexahydrophthalic, methyl-tetrahydrophthalic, nadic methyl, and chlorendic anhydride.

12. The process of claim 1 wherein said mateial comprises the reaction product of hydroxyethyl acrylate and alkyl succinic anhydride.

13. The process of claim 1 wherein said material includes a brominated epoxy acrylate.